# EUROPÄISCHE PATENTANMELDUNG

(11) **EP 2 325 696 A1**
(43) Veröffentlichungstag der Anmeldung: **25.05.2011**
(21) Anmeldenummer: 10010986.7
(22) Anmeldetag: 28.09.2010
(51) Int. Cl.: G03F 7/20, B29C 67/00

(54) **Elektronisch ansteuerbare Matrix-Maske**

(30) Priorität: 19.11.2009 DE 102009054024
(71) Anmelder: Amphenol-tuchel Electronics GmbH, 74080 Heilbronnn (DE)
(72) Erfinder: Schewe, eckhard, 74074 Heilbronn (DE)
(74) Vertreter: Wendels, Stefan

(57) **Zusammenfassung**

Die Erfindung betrifft eine elektronisch ansteuerbare Matrix-Maske bestehend aus einer im wesentlichen ebenen Platte, wobei die Platte als für elektromagnetische Strahlungen innerhalb eines definierten Frequenzbandes transparente Platte ausgebildet ist, in welcher eine Vielzahl von Matrixelementen angeordnet sind, wobei jedes der Matrixelemente als ein elektronisch ansteuerbares Matrixelement ausgebildet ist, derart, dass es beim Ansteuern mit einem Steuersignal einer Steuerung wahlweise in einem lichtdurchlässigen oder einem lichtundurchlässigen Zustand innerhalb eines definierten Frequenzbandes eingestellt werden kann.

## Beschreibung

Die Erfindung betrifft eine elektronisch ansteuerbare Matrix-Maske sowie eine Vorrichtung zur Herstellung von mikromechanischen und mikrooptischen Bauelementen, sowie komplexen dreidimensionalen Strukturen gemäß dem Oberbegriff des Patentanspruch 1 und 7.

Mikromechanische und mikrooptische Bauelemente, sowie kleine dreidimensionale Strukturen werden, wie im Stand der Technik ausführlich dargestellt, durch Galvanikprozesse, Insbesondere Mikrogalvanikprozesse, Laserbearbeitung wie Lasersinterverfahren, Lithographie, Galvanoformung oder Abformung, sowie Ätzen oder anisotropes Ätzen hergestellt.

Auch Kombinationen vorgenannten Verfahren dienen dazu, mikromechanische Bauelemente herzustellen.

Weitere Verfahren zur Herstellung von 3D-Miniaturformen sind die Stersolithographie, das Solid Freeform Manufacturing (SFM), das Lamineted Object Manufacturing (LOM) sowie selektlves Lasersintem. Typische Anwendungsgebiete sind der Formenbau mit kleinen Stückzahlen.

Alle diese Verfahren unterliegen gewissen Nachteilen, wie zum Beispiel, dass Hinterschnitte nicht möglich sind, Rundungen in allen Raumachsen schwierig oder überhaupt nicht herstellbar sind, Hohlkörper nicht erzeugt werden können ohne ganz erhebliche Zusatzaufwendungen. Komplexe mechanische Baugruppen können nicht auf einfache Weise kostengünstig und in großer Stückzahl produziert werden.

Mit den genannten Verfahren lassen sich nur durch aufwendige Maßnahmen Strukturen herstellen, in welche darüber hinaus auch Kontakte oder Kontaktmaterialien beziehungsweise Leiterbahnen eingebettet werden können.

Hierzu beschreibt die DE 44 20 996 ein Verfahren zur Herstellung mikromechanischer Bauelemente, bei dem eine photoinduziert aushärtbare Flüssigkeit zwischen zwei zueinander beabstandeten, in vorgegebenen Schrittweisen in Abhängigkeit von der Schichtenfolge eines in einem Rechner erzeugten 3D-Volumenmodells verfahrbaren, planparallelen Platten, von denen mindestens eine für elektromagnetische Wellen durchlässig ist, mit elektromagnetischer Strahlung eine definierte Frequenz derart bestrahlt wird, dass ein Tropfen, welcher photoinduzierbar und aushärtbar ist, zwischen die planparallelen Platten appliziert wird und entsprechend von den elektromagnetischen Wellen (Licht) ausgehärtet wird.

Der Tropfen wird dabei aufgrund seiner Oberflächenspannung zwischen den Platten gehalten und das in seinem Innere entstehende Bauelement hermetisch nach außen gegen die Atmosphäre abgeschirmt, wobei beim schrittweisen auseinander fahren der Platten Flüssigkeit des Tropfens selbsttätig in dem Bereich zwischen ausgehärteter Schicht und Platte nachströmt.

Wiederholt man diese Verfahrensschritte, lassen sich dadurch Körper schichtweise aus der lichtaushärtbaren Flüssigkeit aufbauen.

Eine Weiterentwicklung des zuvor beschriebenen Verfahrens findet sich in der Patentschrift DE 195 39 039.

Dort wird eine Vorrichtung zur Herstellung von mikromechanischen und mikrooptischen Bauelementen offenbart, welche mit einer elektromagnetischen Wellen aussendender Strahlungsquelle, sowie mit zwei relativ zueinander in vorgegebener Schrittweise in Abhängigkeit von der Schichtfolge eines in einem Rechner erzeugten 3D-Volumenmodells verfahrbaren, planparallelen Platten, von denen mindestens eine für die elektromagnetische Welle durchlässig ist und zwischen den eine photoinduziert aushärtbare Flüssigkeit vorgesehen ist, wobei die Flüssigkeit allein durch ihre Oberflächenspannung zwischen den beiden Platten gehalten und die von Platte zu Platte reichende seitliche Oberfläche der Flüssigkeit mit der Atmosphäre in Verbindung steht und frei zugänglich ist, derart, dass der die elektromagnetischen Wellen aussendenden Strahlungsquelle eine Strahlteileeinrichtung nachgeordnet Ist, wodurch die Teilstrahlen nebeneinander auf eine der Platten gerichtet und auf die mit dieser Platte parallele Flüsslgkeitsoberfläche fokussiert sind.

Nachteilig ist dabei, dass die Lichtquelle jeweils nur fokussierend aushärtet und dadurch eine lange Prozesszeit benötigt wird, um eine Vielzahl von Bauelementen herzustellen.

Werden allerdings hohe Stückzahlen im Serienprozess benötigt, eignen sich diese relativ langsamen Verfahren nicht dazu, die erforderliche Ausbringungsmenge zu erzielen, ohne die Anzahl der Anlagen zu vervielfachen.

Hierzu sieht die nicht veröffentlichte Patentanmeldung Nr, 10 2009 050 325 eine Lösung vor, um dreidimensionale mlkromachanische Bauelemente, vorzugsweise Kontaktiervorrichtungen. schneller herzustellen.

Bei dieser Vorrichtung wird zwischen die Lichtquelle, welche elektromagnetische Strahlung aussendet und der lichtaushärtbaren Flüssigkeit eine optische Maske eingebracht, welche über Bereiche verfügt, welche für elektromagnetische Strahlung durchlässig sind und über Bereiche verfügt, welche für elektromagnetische Strahlung undurchlässig sind,

Hierdurch können selektive Berelche der Flüssigkeit durch die Maske hindurch, gleichzeitig durch eine geeignete, positionierte, elektromagnetische Lichtquelle ausgehärtet werden. Durch geeignete Auswahl der Masken und Anzahl der je Maske durchlässigen Bereiche, lässt sich flächenmäßig gleichzeitig eine größere Anzahl von Bauelementen auf diese Weise relativ kostengünstig herstellen.

Nachteilig bei diesem Verfahren ist, dass je nach Bauhöhe und Form des herzustellenden Teils eine Vielzahl von Masken benötigt werden, die auf einem xy-Tisch an der Vorrichtung angeordnet werden. Bei mehreren Schichten unterschiedlicher Geometrie oder bei einem Aufbau unterschiedlicher Schichtfolgen werden unterschiedliche Masken benötigt. Dies kann dadurch bewerkstelligt werden, dass entweder die Masken nach jeder Schlchtfolge ausgetauscht werden, was zusätzliche, praktische Probleme aufwirft oder aber die Objekte auf einem Träger so angeordnet werden, dass dieser über ein xy-Tisch zu einer anderen Maskenposition verfahren werden kann. Je nach dem wie viele Schichten aufgebracht werden müssen, besteht ein sozusagen serieller Prozess, um die gewünschten dreidimensionalen Volumenmodelle zu erzeugen, welche sich aus der Anzahl der Schichten analog den verwendeten Masken zusammensetzen. Hierbei ist auch zu berücksichtigen, dass die Schichtstärke, je nach Bauteil, unterschiedlich ausfallen muss und nicht beliebige Schichtstärken erzeugt werden können.

Es Ist daher Aufgabe der vorliegenden Erfindung, besagte Vorrichtung so weiterzuentwickeln, dass besagte Nachteile beseitigt sind. Insbesondere soll die Problematik der Herstellung und Verwendung unterschiedlicher Masken, zur Bildung der gewünschten Schichtfolge, vermieden werden.

Diese Aufgabe wird erfindungsgemäß durch eine elektronisch ansteuerbare Matrix-Maske gemäß Anspruch 1 und einer Vorrichtung gemäß Anspruch 7 gelöst.

Die erfindungsgemäße Vorrichtung verfügt daher über eine elektronisch ansteuerbare Matrix-Maske, welche selektiv durchlässig und undurchlässige Bereiche mittels einer Steuerung bereitstellen kann.

Mit Vorteil wird erfindungsgemäß eine elektronisch ansteuerbare Matrix-Maske aus einer Platte, vorzugsweise einer transparenten Platte, vorgesehen, welche für elektromagnetische Strahlung innerhalb eines definierten Frequenzbandes durchlässig ist, wobei innerhalb der Matrix-Maske, mit Vorteil innerhalb der Platte, eine Vielzahl von Matrixelementen angeordnet sind, wobei jedes der Matrixelemente mittels Ansteuern eines Steuersignals in einen lichtdurchlässigen oder einen lichtundurchlässigen Zustand in einem definierten Frequenzband eingestellt werden können. Durch Erhöhung der Anzahl der Matrixelemente, welche wahlweise lichtdurchlässig oder lichtundurchlässig angesteuert werden können, lässt sich die Auflösung der Matrix-Maske einstellen.

Weiterhin vorgesehen ist eine Steuerung, welche x,- und y-Achse der Matrixschablone ansteuem kann, so dass ein rechnergestütztes 3D-Volumenmodell, welches im Rechner in Schichten zerlegt wurde, so an der Matrixschablone schichtweise erzeugbar ist und ein Abbild der entsprechenden Schicht des 3D-Volumenmodelles an der Matrix-Maske einstellbar Ist.

Hierdurch wird verhindert, dass für komplexe Modelle eine Vielzahl von Masken (in Abhängigkeit der Schichthöhe) erstellt werden müssen, um das gewünschte 3D-Volumenmodell zu erzeugen.

Vielmehr lässt sich durch Ansteuerung der elektronischen Matrix-Maske selektiv ein Bereich festlegen, welcher durchlässig ist für die elektromagnetische Strahlung.

Insofern lassen sich sämtliche optische Masken, die benötigt werden, in einem solchen Herstellungsprozess durch die elektronische Matrix-Maske mittels der Steuerung ersetzten, in dem analog zu jeder Maske eine entsprechendes elektronisches Matrixabblld geschaffen wird.

Ein weiterer Vorteil der vorliegenden Erfindung liegt darin, dass der Wechsel der Masken von einer Schicht zur nächsten Schicht durch schnelle elektrische Ansteuerung der Matrix-Maske erfolgen kann, ohne in den Prozess manuell eingreifen zu müssen. Es kann innerhalb kürzester Zeit die nächste Schicht des 3D-Volumenmodelles erzeugt werden.

Folglich können auch niederviskose Kunststoffe schneller verarbeitet werden, da durch die kurzzeitige Veränderung der Matrix-Maske mittels elektronischer Ansteuerung die gewünschte Maskenform erzeugt werden kann, bevor die applizierte lichtaushärtbare Flüssigkeit in Folge ihrer Viskosität bereits soweit auf dem Träger auseinander gelaufen ist, dass eine zu dünne Schichtstärke erzielt werden würde,

Erfindungsgemäß wird daher eine Vorrichtung vorgeschlagen, bei der die Erzeugung eines 3D-Volumenmodell dadurch bewerkstelligt wird, dass eine, wie zuvor beschriebene elektronisch ansteuerbare Matrix-Maske, zwischen eine Lichtquelle und dem zu entstehenden lichtaushärtbaren Flüssigkeitsfilm angeordnet wird. Gemäß dem rechnergestützten 3D-Volumenmodell werden schichtweise lichtundurchlässige Bereiche und lichtundurchlässige Bereiche so in der Matrix-Maske erzeugt, dass die jeweils gewünschte Schicht durch Lichtaushärtung gebildet wird.

Die Erfindung wird nachfolgend unter Bezugnahme auf die Zeichnungen näher erläutert. In den Zeichnungen zelgen:
Fig. 1 eine schematische Vorderansicht einer erfindungsgemäßen Anlage zur Herstellung mikromechanischer oder mikrooptischer Bauelemente aus einem Rechnergestützten 3D-Volumenmodell;
Fig. 2 eine schematische Ansicht einer elektronisch ansteuerbaren Matrix-Maske.

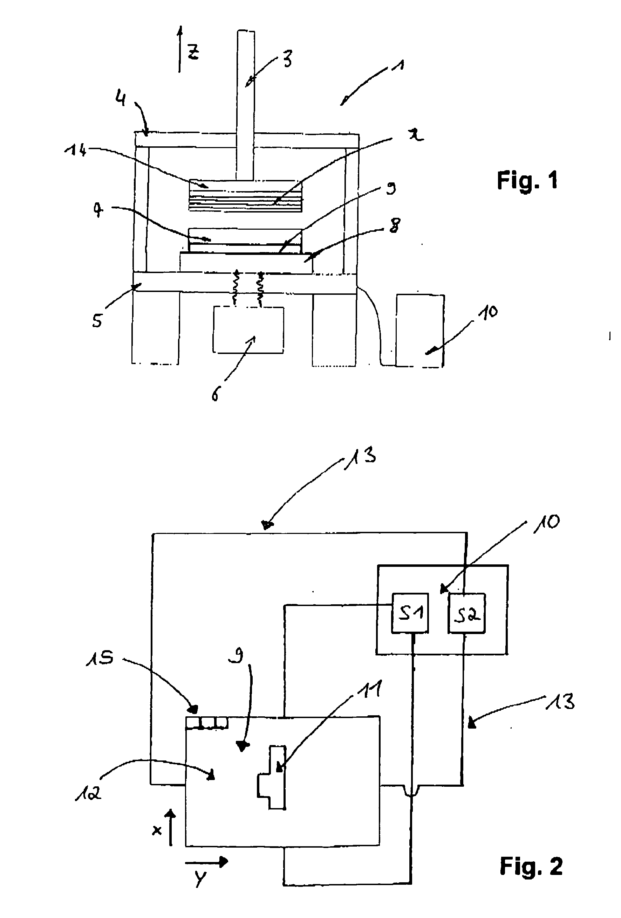

Fig. 1 zeigt eine schematische Seitenansicht einer erfindungsgemäßen Vorrichtung 1 zur Herstellung dreidimensionaler Bauelemente oder Volumenkörper aus lichtaushärtbaren Flüssigkeiten. vorzugsweise photoinduziert Ilchtaushärtbaren Flüsslgkelten.

Im oberen Teil der Anlage befindet sich mittig angeordnet eine Hubvorrichtung 3, die Ober eine Haltevorrichtung 4 auf einem Tisch, vorzugsweise einem Granittisch, angeordnet ist. Unterhalb des Tisches 5 befindet sich eine Belichtungseinheit 6, welche dazu geeignet ist, elektromagnetische Strahlung durch die Tschplatte 5 zu emittieren. Ober diese Belichtungseinheit 6 wird in ein durch lichtaushärtbaren Kunststoff enthaltenes Reservoir 7 Licht eingestrahlt, welches durch den Tisch 5 und einer darüber aufgebrachten, erfindungsgemäßen, ansteuerbaren, elektronischer Matrix-Maske 9, welche auf einem xy-Tisch 8 zur Justierung befestigt ist. Durch den xy-Tisch 8 lässt sich die genaue Position der elektronisch ansteuerbaren Matrix-Maske 9 einrichten. Rechts daneben ist in der Fig. 1 eine Steuereinheit 10 dargestellt, welche, die erfindungsgemäße Matrix-Maske 9 und die Vorrichtung ansteuern kann, um den zuvor beschriebenen Prozess automatisiert oder zumindest teilautomatisiert durchführen zu können. An der Hubvorrichtung 3 befindet sich ein Warenträger 14, an welcher das dreidimensionale herzustellende Volumenelement 2 angeordnet ist, welches hier vereinfacht in der Fig, 1 als ein quaderförmiger Körper dargestellt ist.

Alternativ zu dem Reservoir 7, in welche die lichtaushärtbare Flüssigkeit beziehungsweise der lichtaushärtbare Kunststoff eingefüllt wird, kann auch eine entsprechend der Schichtstärke auszubildender Flüssigkeitsfilm auf die Unterseite des Warenträgers 14 aufgetragen werden, welcher dann durch die Maske 9 hindurch beschichtet wird.

Nach Ausbildung der gewünschten Schicht kann der Warenträger 14 mittels der Hubvorrichtung 3 in Z-Richtung nach oben bewegt werden und auf die bereits gebildete Schicht eine neue Schicht oder ein Film des lichtaushärtbaren flüssigen Kunststoffs aufgebracht werden. Gleichzeitig können in diesen Film manuell Kontakte eingebracht werden, welche dann zusammen mit dem Warenträger 14 wieder nach unten oberhalb der Maske gefahren werden, durch welche hindurch die dann zu bildende Schicht verfestigt wird. Dieser Prozess wird entsprechend dem gewünschten Volumenmodell nach Anzahl der Schichten wiederholt, bis das fertige Bauelement erzeugt ist.

Mit Vorteil können in der zuletzt beschriebenen Ausführung auch Kunststoffe unterschiedlichen Materials nacheinander aufgebracht werden, was bei einem Reservoir 7 sich praktisch deutlich schwieriger gestaltet.

In Fig. 2 dargestellt Ist das Kernstück der Erfindung aus Fig. 1, nämlich die elektronisch ansteuerbare erfindungsgemäße Matrix-Maske 9.

Die Matrix-Maske 9 verfügt über eine xy-Matrix, welche als ein Matrixfeld mit einer Vielzahl von ansteuerbaren Matrixelementen 15 ausgebildet ist, welche mittels einer Steuerung 10 angesteuert werden können. Als Matrixelement können beliebige, am Markt verfügbare Einheiten, mit den beschriebenen Eigenschaften verwendet werden.

Der Einfachheit halber sind in Fig. 2 ledigllch exemplarisch drei Matrixelemente 15 abgebildet. Die Anzahl und Position der Matrixelemente in der xy-Matrix kann entsprechend den Anforderungen angepasst werden.

Dabei bewirkt die Steuerung 10, dass die Matrixelemente 15 durch Anlegen einer Steuerspannung U lichtdurchlässig werden können beziehungsweise durch Entfernen der Steuerspannung U transparent werden oder umgekehrt. Die Größe und Anzahl der Matrixelemente 15 beeinflusst die Auflösung der erfindungsgemäßen Vorrichtung.

Sofern die Anzahl der Matrixelemente 15 in xy-Richtung ausreichend hoch bemessen lst, erhöht sich dadurch entsprechend die Auflösung der transparenten elektronischen Matrix-Maske 9.

Mit Vorteil verfügt die Steuerung 10 über eine erste Steuerung S1 und eine zweite Steuerung S2, welche jeweils über Steuerleitungen 13 mit jedem Matrixelement 15 R verbunden ist. Dadurch steuert jede der Steuereinheiten S1 und S2 in jedem der Matrixelemente 15 die x,- und y-Komponente derart, dass an bellebiger Stelle der Matrix-Maske mittels der Steuerung entweder ein lichtundurchlässiger Bereich oder ein lichtdurchlässiger, sprich transparenter Bereich erzeugt werden kann.

Erfindungsgemäß kann dadurch eine wie in Fig. 2 gezeigte Maske erzeugt werden, bei dem ein Bereich 12 als lichtundurchlässig für die elektromagnetische Strahlung der Lichtquelle 6 ausgebildet lst und ein Bereich 11 als lichtdurchlässiger Bereich für die elektromagnetische Strahlung der Lichtquelle 6 ausgebildet ist.

Mit Vorteil lst die Steuerung direkt ansteuerbar von einer CAD-Anlage und dem darin errechnetem Schichtenmodell eines 3D-Volumenmodelles. Dabei wird das zu erzeugende 3D-Volumenmodell in definierte Schichten zerlegt und zur Erzeugung der entsprechenden Lage wird die Schichtstruktur auf der Matrix mittels der Steuerung 10 abgebildet, so dass eine korrespondierende Abbildung in der belichteten lichtaushärtbaren Flüssigkeit durch die Matrix-Maske hindurch erzeugt werden kann.

In dem jeweils darauf folgenden Verfahrensschritt wird die aus dem 3D-Volumenmodell benachbarte Schicht über die Steuerung 10 an die Matrix-Maske 9 gesendet, so dass schrittweise durch Aushärtung der jeweiligen Schicht durch die entsprechende Maskenanordnung das 3D-Volumenmodell erzeugt wird. Hierbei wird nach jedem Schritt die Hubvorrichtung 3 in Z-Richtung um die gewünschte Schichtstärke, welche der Dicke der einzelnen berechneten Schichten aus dem 3D-Volumenmodell entspricht, verfahren. Die Auflösung und damit Genauigkeit lässt sich dadurch erhöhen, dass man die Schichtstärke reduziert und gleichennaßen den Verfahrweg der Hubvorrichtung 3 entsprechend der Schichtstärke anpasst

Mit Vorteil ist dabei zu erkennen, dass bei einer Verdoppelung der Schichten und Halbierung der Schichtdicken es nicht notwendig wird, die doppelte Anzahl von Masken mechanisch bereit zu stellen, sondern diese mittels der erfindungsgemäßen, elektronisch ansteuerbaren Matrix-Maske 9 unmittelbar aus dem 3D-Volumenmodell einer CAD-Anlage errechenbar ist.

Somit ist der Anwender nicht mehr dran gehindert, die Genauigkeit aus Kostengründen zu reduzieren, sondern er kann diese in Abhängigkeit seiner Rechnersteuerung auf die entsprechende Applikation anwenden. Die Auflösung in xy-Richtung, also in der Ebene senkrecht zur Achse z der Hubvorrichtung 3, kann, wie bereits zuvor erläutert, durch die Anzahl der Matrixelemente 15 je Flächeneinheit erhöht oder verringert werden.

Die erfindungsgemäße Vorrichtung kann auch zur Herstellung und Beschichtung von Leiterplatten oder anderen abbildenden Verfahren verwendet werden, bei dem anstelle einer Folienmaske der Einsatz der erfindungsgemäßen elektronisch ansteuerbaren Matrix-Maske 9 Verwendung finden kann.

### Bezugszeichenliste

### Elektronisch ansteuerbare Matrix-Maske

- 1: Vorrichtung
- 2: 3D-Volumenelement
- 3: Hubvorrichtung
- 4: Haltevorrichtung
- 5: Tisch
- 6: Beleuchtungseinheit
- 7: Reservoir mit lichtaushärtbarem Kunststoff
- 8: xy-Tisch
- 9: erfldungsgemäße elektronisch ansteuerbare Matrix-Maske (kurz: Matrix-Maske)
- 10: Steuerung
- 11 1: transparenter Bereich (lichtdurchlässiger Bereich)
- 12: lichtundurchlässiger Bereich
- 13: Steuerleitungen
- 14: Warenträger
- 15: Matrlxelemente

## Patentansprüche

1. Elektronisch ansteuerbare Matrix-Maske (9) bestehend aus einer im wesentlichen ebenen Platte (14), wobei die Platte (14) als für elektromagnetische Strahlungen innerhalb eines definierten Frequenzbandes transparente Platte (14) ausgebildet ist, in welcher eine Vielzahl von Matrixelementen (15) angeordnet sind, **dadurch gekennzeichnet, dass** jedes der Matrixelemente (15) als ein elektronisch ansteuerbares Matrixelement (15) ausgebildet ist, derart, dass es beim Ansteuern mit einem Steuersignal einer Steuerung (10) wahlweise in einem lichtdurchlässigen oder einem lichtundurchlässigen Zustand innerhalb eines definierten Frequenzbandes eingestellt werden kann.

2. Elektronisch ansteuerbare Matrix-Maske (9) gemäß Anspruch 1, **dadurch gekennzeichnet, dass** die Matrixelemente (15) in Reihen und Spalten in der x, y-Ebene in der Platte (14) angeordnet sind.

3. Elektronisch ansteuerbare Matrix-Maske (9) gemäß Anspruch 1 oder 2, **dadurch gekennzeichnet, dass** eine Steuerung (10) vorgesehen ist, welche mittels Steuerleitungen (13) mit der elektronisch ansteuerbaren Matrix-Maske (9) so verbunden ist, um diese in Bezug auf den Status der selektiven Lichtdurchlässlgkeit anzusteuern.

4. Elektronisch ansteuerbare Matrix-Maske (9) gemäß Anspruch 3, **dadurch gekennzeichnet, dass** die Steuerung (10) über zwei Steuereinheiten (S1, S2) verfügt, bei der jede der Steuereinheiten (S1, S2) mit jeweils einem jeden der Matrixelemente (15) verbunden ist, um jedes der Matrixelemente (15) unabhängig Voneinander ansteuem zu können.

5. Elektronisch ansteuerbare Matrix-Maske (9) gemäß Anspruch 4, **dadurch gekennzeichnet, dass** die Durchlässigkeit der Matrixelemente (15) für Licht einer bestimmten Frequenz mittels einer Steuerspannung erzeugt wird, welche durch die Steuereinheiten (S1, S2) an jedem der Matrixelemente (15) angelegt werden kann.

6. Elektronisch ansteuerbare Matrlx-Maske (9) gemäß einem der vorhergehenden Ansprüche, **dadurch gekennzeichnet, dass** die Matrixelemente (15) über je zwei Anschlüsse verfügen, wobei jeweils ein erster Anschluss der Steuerung (S1) und ein zweiter Anschluss der Steuerung (S2) zugeordnet ist, derart, dass die Steuereinheiten (S1, S2) gleichzeitig eine ausgewählte Anzahl von Matrixelementen (15) so ansteuert, dass diese entweder alle gleichzeitig lichtdurchlässig oder alle gleichzeitig lichtundurchlässig werden und sich **dadurch** definierte Bereiche (11,12) innerhalb der Platte (14) ergeben, welche Licht In einem bestimmten Frequenzbereich entweder durchlassen oder absorbieren.

7. Vorrichtung (1) zur Herstellung von dreidimensionalen Volumenkörpem mittels elektromagnetischer Strahlung einer Beleuchtungseinheit (6) mittels einer photoinduziert, lichtaushärtbaren Flüssigkeit umfassend
- ein Produktträger (12) ausgebildet an einer Hubvonichtung (3), welcher beweglich in Z-Richtung in ein Reservoir (7) der Vorrichtung (1) mit einem Warenträger (14) eintauchen kann, welche mit lichtaushärtbarer Flüssigkeit beaufschlagt werden kann, sowie einer zwischen dem Reservoir (7) und einer Beleuchtungseinheit (6) angeordneter Matrix-Maske (9) gemäß einem der vorhergehenden Ansprüche 1 bis 6.
